## Europäisches Patentamt
## European Patent Office
## Office européen des brevets

(19)

(11) Numéro de publication : **0 351 285 B1**

(12)

# FASCICULE DE BREVET EUROPEEN

(45) Date de publication du fascicule du brevet :
**15.01.92 Bulletin 92/03**

(51) Int. Cl.$^5$ : **G01V 1/20,** B06B 1/06, H01L 41/08

(21) Numéro de dépôt : **89401910.8**

(22) Date de dépôt : **04.07.89**

(54) **Capteur piézo-électrique comportant au moins une paire d'éléments sensibles souples de grande longueur.**

(30) Priorité : **11.07.88 FR 8809519**

(43) Date de publication de la demande :
**17.01.90 Bulletin 90/03**

(45) Mention de la délivrance du brevet :
**15.01.92 Bulletin 92/03**

(84) Etats contractants désignés :
**DE GB IT NL**

(56) Documents cités :
**EP-A- 0 251 901**
**EP-A- 0 297 948**
**FR-A- 2 145 099**

(73) Titulaire : **INSTITUT FRANCAIS DU PETROLE**
**4, Avenue de Bois-Préau**
**F-92502 Rueil-Malmaison (FR)**

(72) Inventeur : **Beauducel, Claude**
**8, rue Talon**
**F-60119 Henonville (FR)**
Inventeur : **Bolze, Etienne**
**96 ter, Boulevard Bellerive**
**F-92500 Rueil Malmaison (FR)**

Jouve, 18, rue Saint-Denis, 75001 PARIS

EP 0 351 285 B1

**Description**

L'invention a pour objet un capteur piézo-électrique perfectionné comportant une ou plusieurs paires d'éléments sensibles de grande longueur.

Un tel capteur peut notamment être utilisé comme hydrophone pour différentes opérations en mer et par exemple en prospection sismique marine pour recevoir les ondes sismiques, émanant du sous-sol immergé, qui ont été transmises par une source sismique marine et renvoyées par les discontinuités géologiques souterraines.

Les éléments sensibles sont constitués d'un substrat possédant des propriétés piézo-électriques et de deux électrodes disposées de part et d'autre de ce substrat.

Le substrat peut aussi être réalisé sous la forme de rubans ou de plaques souples réalisés à partir d'un matériau synthétique plastique auquel un traitement confère des propriétés piézo-électriques. On utilise généralement des matériaux tels que le PVDF (polyfluorure de vinylidène), le polyéthylène, le PTFE (polytétrafluorure d'éthylène) etc.

Les éléments sensibles souples s'emploient le plus souvent sous la forme de rubans ou de bandes disposés sur un support plan ou bien enroulés en hélice autour d'un noyau cylindrique. On les combine généralement par deux de manière à augmenter la sensibilité de l'ensemble. En les disposant de part et d'autre d'un support avec des polarités opposées et en les connectant électriquement, on obtient une compensation des tensions parasites naissant des flexions du support et des accélérations.

Par l'emploi de bandes souples, on peut construire des hydrophones continus de longueur relativement grande qui réalisent des filtrages en nombre d'onde. Incorporés dans des flûtes sismiques remorquées par un navire, ils permettent notamment de filtrer certains bruits parasites et de faciliter la réception des signaux renvoyés par des discontinuités du sous-sol immergé, en réponse à des ondes sismiques émises par une source remorquée.

Suivant un agencement connu, on constitue un récepteur piézo-électrique en enroulant en hélice sur un noyau cylindrique isolant, une première bande sensible associée à ses deux électrodes. Une bande souple isolante est superposée par enroulement à la première bande sensible. Par dessus, on enroule encore, suivant une hélice de sens inverse de la première, une seconde bande sensible. Des bagues en contact respectivement avec les électrodes des deux bandes sensibles, sont reliées par des fils conducteurs de manière à réaliser une interconnexion en série.

Suivant un autre agencement connu, on peut interposer entre les deux enroulements hélicoïdaux croisés, un ruban conducteur mince transparent aux ondes acoustiques. Le ruban recouvre les bords latéraux de toutes les spires de l'enroulement inférieur et établit un bon contact électrique entre son électrode supérieure et l'électrode inférieure de l'enroulement superposé, ce qui contribue à diminuer la résistance électrique des connexions et améliore la fiabilité électrique.

De tels capteurs piézo-électriques sont décrits dans le brevet français n° 2.145.099 ou les demandes de brevet français publiées n° 2.601.132 ou 2.603.422 par exemple.

La présente invention concerne un capteur piézo-électrique perfectionné constitué à partir d'éléments sensibles comprenant chacun un substrat réalisé en un matériau souple présentant des propriétés piézo-électriques et deux électrodes fines disposées de part et d'autre du substrat, ce capteur étant agencé pour simplifier les opérations de fabrication et offrir une fiabilité accrue.

Il est caractérisé en ce que les éléments sensibles sont entrecroisés de façon que les deux électrodes de chacun d'eux soient alternativement en contact électrique avec une des électrodes d'au moins un autre élément sensible.

Le capteur peut comporter par exemple au moins deux éléments sensibles entrecroisés de manière que chaque électrode de l'un des éléments sensibles soit en contact électrique alternativement avec les deux électrodes de l'autre élément sensible.

Suivant un mode de réalisation, le capteur peut comporter au moins une tresse d'éléments sensibles constituée chacun d'au moins une paire d'éléments sensibles enroulés en hélices de sens opposés et entrecroisées. Cette tresse est disposée par exemple sur un noyau central sensiblement cylindrique ou bien encore aplati.

L'entrecroisement des éléments sensibles présente de nombreux avantages :

1) Les deux éléments sensibles de chaque paire jouent le même rôle du fait que chacun d'eux se trouve alternativement au-dessus et au-dessous de l'autre. Leurs réponses respectives aux contraintes exercées sont très semblables. Dans tous les modes de réalisation où les éléments sensibles de chaque paire sont agencés et interconnectés pour assurer une compensation des contraintes anisotropes, celles dues notamment aux accélérations, le capteur revendiqué offre une meilleure immunité au bruit ;

2) Du fait de l'entrecroisement des éléments sensibles qui multiplie les zones de contact entre leurs électrodes respectives :

— les résistances de connexions sont plus faibles, ce qui contribue à élargir la bande passante,

— le nombre total de connexions électriques nécessaire à la combinaison électrique des éléments sensibles de chaque paire est plus faible ;

— une coupure éventuelle localisée sur un quelconque des films conducteurs constituant les électrodes des deux éléments sensibles de chaque paire est sans conséquence notable, ce qui permet d'obtenir plus facilement des spécifications correctes.

3) Du seul fait de l'entrecroisement, la tenue mécanique de chaque ensemble d'éléments sensibles est assurée. L'adjonction de moyens de liaison mécanique n'est plus indispensable pour obtenir sa cohésion.

D'autres caractéristiques et avantages du capteur selon l'invention apparaitront à la lecture de la description de modes de réalisation donnés à titre d'exemples non limitatifs, en se référant aux dessins annexés où :

— la figure 1 représente schématiquement en coupe un élément sensible ;

— la figure 2 représente dans le cas général un entrecroisement de plusieurs éléments sensibles ;

— la figure 3 montre en coupe la disposition relative d'un premier élément sensible par rapport à un second élément sensible à leur entrecroisement ;

— la figure 4 montre en coupe la disposition relative du même élément sensible par rapport à un troisième élément à un entrecroisement adjacent ;

— la figure 5 montre schématiquement un premier mode de réalisation du capteur comportant une paire d'éléments sensibles enroulés sur un support cylindrique ;

— la figure 6 montre schématiquement un second mode de réalisation du capteur comportant une pluralité d'éléments sensibles entrecroisés ; et

— la figure 7 montre schématiquement un troisième mode de réalisation du capteur où une pluralité d'éléments sensibles sont disposés sur un support aplati.

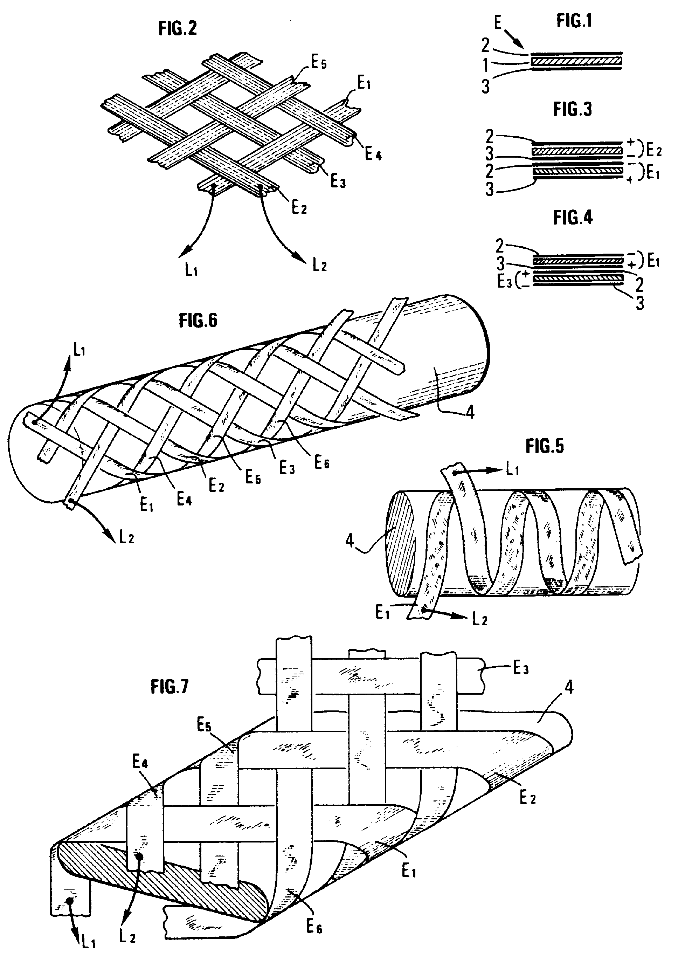

Chaque élément sensible est réalisé par exemple sous la forme d'une bande allongée comportant (fig. 1) un ruban mince 1 réalisé en un matériau présentant des propriétés piézo-électriques sur les faces opposées duquel sont déposés deux films conducteurs 2, 3 constituant les électrodes.

Dans sa forme la plus générale (fig. 2) le capteur selon l'invention comporte une première rangée de plusieurs éléments sensibles $E_2$, $E_3$, $E_4$ etc entrecroisée avec une seconde rangée d'éléments sensibles $E_1$, $E_5$ etc. L'élément $E_1$ de la seconde rangée par exemple croise successivement les éléments $E_2$, $E_3$, $E_4$ etc de la première rangée. On le dispose de manière qu'il passe successivement au-dessous de $E_2$, au-dessus de $E_3$, au-dessous de $E_4$ etc. A un premier croisement quelconque, sa première électrode 2 par exemple, est en contact avec la seconde électrode 3 de $E_2$ (superposition telle que sur la figure 3). Au croisement suivant, c'est sa seconde électrode 3 qui se trouve au contact avec la première électrode 2 de l'élément sensible $E_3$. L'électrode 2 de $E_1$ est de nouveau au contact à l'intersection avec $E_4$. De la même façon, tout élément de la première rangée $E_2$, $E_3$, $E_4$... passe successivement au-dessus et au-dessous des éléments sensibles de la seconde rangée et une quelconque de ses électrodes met en contact électrique une même électrode (2 ou 3) des éléments sensibles de la seconde rangée $E_1$, $E_5$ etc, à deux rangs de distance les unes des autres. La distance entre les éléments sensibles d'une même rangée peut être quelconques mais il est possible de les agencer suivant un quadrillage régulier. Quel que soit l'espacement entre éléments sensibles, le mode de croisement choisi assure à la fois une certaine tenue mécanique de l'ensemble et, du fait des contacts multiples entre les électrodes, une mise en parallèle des différents éléments sensibles qui le constituent. Pour capter la tension que développe l'ensemble d'éléments sensibles en réponse à des contraintes et l'appliquer à un préamplificateur, approprié il suffit de deux conducteurs $L_1$ et $L_2$ soudés à deux électrodes opposées. Le capteur ainsi constitué peut être déposé sur un support de forme quelconque.

Suivant le mode de réalisation de la figure 5, le capteur peut être réalisé en enroulant au moins une paire d'éléments sensibles sur un support. Les deux enroulements $E_1$, $E_2$ d'une même paire sont disposés suivant deux hélices de sens opposés. A chaque croisement, un même élément sensible est alternativement au-dessus et au-dessous de l'autre élément sensible de la même paire. Si le capteur comporte une pluralité d'éléments sensibles (fig. 6), chacun d'eux est enroulé en hélice et disposé alternativement au-dessus et au-dessous des éléments sensibles qu'il croise successivement. De cette manière, on réalise également une interconnexion mécanique et électrique des différents éléments sensibles. A une extrémité du support, deux conducteurs électriques $L_1$ et $L_2$ suffisent à connecter la combinaison en parallèle des éléments sensibles, à l'entrée d'un préamplificateur approprié.

La forme du support peut être quelconque. On peut choisir un support cylindrique plein ou tubulaire de forme plus ou moins aplatie (fig. 5). On peut aussi bien utiliser un support (fig. 7) plat dont les faces planes opposées sont raccordées l'une à l'autre par des parties arrondies. Leur rayon de courbure doit être suffisant pour éviter toute cassure des éléments sensibles et provoquer des micro-coupures des films conducteurs servant d'électrodes.

L'entrecroisement permanant des spires que l'on réalise par bobinage d'une ou plusieurs paires d'éléments sensibles, permet d'obtenir une structure stable qui se tient toute seule. Il n'est donc pas nécessaire d'ajouter durant la fabrication du capteur, des moyens de fixation pour maintenir en place les bobinages superposés. Si une gaine est disposée autour du capteur, après sa fabrication, elle suffit généralement pour stabiliser les spires autour du support. Les opérations de fabrication s'en trouvent donc simplifiées.

**Revendications**

1. Capteur piézo-électrique perfectionné constitué à partir d'éléments sensibles ($E_1$, $E_2$...) comprenant chacun un substrat (1) réalisé en un matériau souple présentant des propriétés piézo-électriques et deux électrodes fines (2, 3) disposées de part et d'autre du substrat, caractérisé en ce que les éléments sensibles sont entrecroisés de façon que les deux électrodes de chacun d'eux soient alternativement en contact électrique avec une des électrodes d'au moins un autre élément sensible.

2. Capteur selon la revendication 1, caractérisé en ce qu'il comporte au moins deux éléments sensibles entrecroisés de manière que chaque électrode de l'un des éléments sensibles soit en contact électrique alternativement avec les deux électrodes de l'autre élément sensible.

3. Capteur selon la revendication 1, caractérisé en ce qu'il comporte au moins une tresse d'éléments sensibles constituée chacune d'au moins deux éléments sensibles enroulés en hélice de sens opposés et entrecroisés.

4. Capteur selon la revendication 3, caractérisé en ce que ladite tresse est disposée sur un noyau central (4) sensiblement cylindrique.

5. Capteur selon la revendication 3, caractérisé en ce que ladite tresse est disposée autour d'un noyau central aplati.

6. Capteur selon la revendication 1, caractérisé en ce que ladite tresse est disposée autour d'un support comportant une plaque aux bords arrondis.

7. Capteur selon la revendication 1, caractérisé en ce qu'il comporte une pluralité d'éléments sensibles entrecroisés, chacun des électrodes de chaque élément sensible étant en contact à intervalles réguliers avec une même électrode d'un autre élément sensible.

8. Capteur selon la revendication 7, caractérisé en ce qu'il comporte deux éléments sensibles disposés en enroulements hélicoïdaux entrecroisés pour réaliser la mise en contact des électrodes à intervalles réguliers.

**Patentansprüche**

1. Piezoelektrischer verbesserter Wandler aufgebaut, ausgehend von empfindlichen Elementen ($E_1$, $E_2$...), die je ein Substrat (1) umfassen, das aus einem nachgiebigen piezoelektrische Eigenschaften aufweisenden Material hergestellt ist, sowie zwei dünnen zu beiden Seiten des Substrats angeordneten Elektroden (2, 3), dadurch gekennzeichnet, daß die empfindlichen Elemente derart gekreuzt oder verflochten sind, daß die beiden Elektroden von jedem hiervon alternativ in elektrischem Kontakt mit einer der Elektroden wenigstens eines anderen empfindlichen Elements stehen.

2. Wandler nach Anspruch 1, dadurch gekennzeichnet, daß er wenigstens zwei empfindliche gekreuzte bzw. verflochtene Elemente derart aufweist, daß jede Elektrode eines der empfindlichen Elemente in elektrischem Kontakt alternativ mit den beiden Elektroden des anderen empfindlichen Elements steht.

3. Wandler nach Anspruch 1, dadurch gekennzeichnet, daß er wenigstens eine Litze aus empfindlichen Elementen umfaßt, die je aus wenigstens zwei empfindlichen Elementen aufgebaut ist, die spiralförmig mit entgegengesetztem Sinn gewickelt und gekreuzt sind.

4. Wandler nach Anspruch 3, dadurch gekennzeichnet, daß diese Litze auf einem mittigen im wesentlichen zylindrischen Kern (4) angeordnet ist.

5. Wandler nach Anspruch 3, dadurch gekennzeichnet, daß diese Litze um einen abgeflachten mittigen Kern angeordnet ist.

6. Wandler nach Anspruch 1, dadurch gekennzeichnet, daß diese Litze um einen Träger angeordnet ist, der eine Platte mit abgerundeten Rändern umfaßt.

7. Wandler nach Anspruch 1, dadurch gekennzeichnet, daß er wenigstens eine Vielzahl empfindlicher gekreuzter Elemente umfaßt, wobei jede der Elektroden jedes empfindlichen Elements in Kontakt — unter regelmäßigen Intervallen — mit ein und der gleichen Elektrode eines anderen empfindlichen Elements steht.

8. Wandler nach Anspruch 7, dadurch gekennzeichnet, daß er zwei empfindliche Elemente umfaßt, die in gekreuzten Spiralwicklungen angeordnet sind, um die Kontaktierung der Elektroden unter regelmäßigen Intervallen bzw. Abständen herbeizuführen.

**Claims**

1. An improved piezoelectric sensor made up of sensitive elements ($E_1$, $E_2$...) each comprising a substrate (1) made of a flexible material with piezoelectric properties and two fine electrodes (2, 3) arranged on either side of the substrate, characterised in that the sensitive elements re interlaced in such a way that the two electrodes of each of them are alternately in electrical contact with one of the electrodes of at least one other sensitive element.

2. Sensor in accordance with claim 1, characterised in that it comprises at least two sensitive elements interlaced in such a way that each electrode of one of the sensitive elements is alternately in electrical contact with the two electrodes of the other sensitive element.

3. Sensor in accordance with claim 1, characterised in that it comprises at least one group of sensitive elements each comprising at least two sensitive elements wound helically in opposite directions and interlaced.

4. Sensor in accordance with claim 3, characterised in that the group is arranged around a substantially cylindrical central core (4).

5. Sensor in accordance with claim 3, characterised in that the group is arranged around a flattened central core.

6. Sensor in accordance with claim 1, characterised in that the group is arranged around a support comprising a plate with rounded edges.

7. Sensor in accordance with claim 1, characterised in that it comprises a plurality of interlaced sensitive elements, each of the electrodes of each sensitive element being in contact at regular intervals with a same electrode of another sensitive element.

8. Sensor in accordance with claim 7, characterised in that it comprises two sensitive elements wound helically and interlaced to achieve contact between the electrodes at regular intervals.

FIG.2

FIG.1

FIG.3

FIG.4

FIG.6

FIG.5

FIG.7